# FASCICULE DE BREVET EUROPEEN

(11) **EP 3 707 751 B1**
(45) Date de publication et mention de la délivrance du brevet: **20.10.2021**
(21) Numéro de dépôt: 18812238.6
(22) Date de dépôt: 06.11.2018
(51) Int. Cl.: H01L 27/15, H01L 33/00, H01L 33/38, H01L 25/075

(54) **PROCÉDÉ DE FABRICATION D'UN DISPOSITIF OPTOÉLECTRONIQUE COMPRENANT UNE PLURALITÉ DE DIODES**
VERFAHREN ZUR HERSTELLUNG EINER OPTOELEKTRONISCHEN VORRICHTUNG MIT EINER VIELZAHL VON DIODEN
MANUFACTURING PROCESS OF AN OPTOELECTRONIC DEVICE COMPRISING A PLURALITY OF DIODES

(30) Priorité: 10.11.2017 FR 1760578
(43) Date de publication de la demande: 16.09.2020
(73) Titulaire: Commissariat à l'Energie Atomique et aux Energies Alternatives, 75015 Paris (FR); Thales, 92400 Courbevoie (FR)
(72) Inventeur: BONO, Hubert, 38000 Grenoble (FR); SIMON, Julia, 38100 Grenoble (FR)
(74) Mandataire: Cabinet Beaumont
(86) Numéro de dépôt international: PCT/FR2018/052742
(87) Numéro de publication internationale: WO 2019/092357

(56) Documents cités:
- EP-A1- 3 024 030
- WO-A1-2017/037530
- WO-A1-2017/068029
- US-A1- 2015 108 514
- US-A1- 2015 333 047

## Description

La présente demande de brevet revendique la priorité de la demande de brevet français 17/60578.

### Domaine

La présente demande concerne le domaine des dispositifs optoélectroniques. Elle concerne plus particulièrement un procédé de fabrication d'un dispositif optoélectronique comportant une pluralité de diodes semiconductrices, par exemple au nitrure de gallium, et un circuit électronique de contrôle de ces diodes.

### Exposé de l'art antérieur

On a déjà proposé un dispositif d'affichage émissif comportant une matrice de diodes électroluminescentes (LED) au nitrure de gallium (GaN), et un circuit de contrôle permettant de commander individuellement les LED pour afficher des images.

Pour réaliser un tel dispositif, on peut prévoir de fabriquer séparément le circuit de contrôle et la matrice de LED, puis de les hybrider, c'est-à-dire de les empiler en les connectant l'un à l'autre.

Un inconvénient de cette méthode de fabrication réside dans la nécessité d'aligner précisément le circuit de contrôle et la matrice de LED lors de l'étape d'assemblage de ces deux éléments, de façon que chaque LED vienne bien se positionner sur un plot métallique qui lui correspond dans le circuit de contrôle. Cet alignement est notamment difficile à réaliser lorsque le pas des pixels diminue, et constitue un frein à l'augmentation de la résolution et/ou de la densité d'intégration des pixels.

Pour pallier cet inconvénient, il a été proposé, notamment dans la demande de brevet internationale N°PCT/FR2016/051140 déposée par le demandeur le 13 mai 2016, de :
réaliser d'abord le circuit de contrôle sous la forme d'un circuit intégré comportant, sur une face, une pluralité de plots métalliques destinés à être connectés aux LED de façon à permettre de contrôler individuellement le courant circulant dans chaque LED ;
rapporter ensuite sur la face du circuit de contrôle comportant les plots métalliques un empilement actif de LED s'étendant de façon continue sur toute la surface du circuit de contrôle ; puis
structurer l'empilement actif de LED pour délimiter et isoler les unes des autres les différentes LED du dispositif.

Un avantage de ce procédé de fabrication est que, lors de l'étape de report de l'empilement actif de LED sur le circuit de contrôle, les positions des différentes LED du dispositif dans l'empilement actif ne sont pas encore définies. Il n'y a par conséquent pas de contrainte forte en termes de précision d'alignement lors du report. La délimitation des différentes LED dans l'empilement actif peut ensuite être réalisée par des procédés de structuration d'un substrat et de dépôt de couches isolantes et conductrices sur un substrat, qui offrent une précision d'alignement nettement supérieure à la précision qui peut être obtenue lors d'un report d'un substrat sur un autre.

Il serait toutefois souhaitable d'améliorer au moins en partie certains aspects du procédé décrit dans la demande N°PCT/FR2016/051140 susmentionnée.

US 2015/333047 A1 divulgue un autre procédé de l'art antérieur.

### Résumé

Ainsi, un mode de réalisation selon l'invention prévoit un procédé selon la revendication 1 de fabrication d'un dispositif optoélectronique, comportant les étapes suivantes :
a) rapporter, sur une face d'un circuit intégré de contrôle comportant une pluralité de plots métalliques de connexion, un empilement actif de diode comportant au moins des première et deuxième couches semiconductrices dopées de types de conductivité opposés, de façon que la deuxième couche de l'empilement soit électriquement connectée aux plots métalliques du circuit de contrôle ;
b) former dans l'empilement actif des tranchées délimitant une pluralité de diodes connectées à des plots métalliques distincts du circuit de contrôle ;
c) déposer une couche isolante sur les parois latérales des tranchées ;
d) retirer partiellement la couche isolante de façon à libérer les flancs des portions de la première couche semiconductrice délimitées par les tranchées ; et
e) former une métallisation revêtant les parois latérales et le fond des tranchées et contactant les flancs des portions de la première couche semiconductrice délimitées par les tranchées.

Selon un mode de réalisation, le procédé comporte en outre, avant l'étape a), au moins l'une des étapes suivantes :
une étape de dépôt d'au moins une première couche métallique sur sensiblement toute la surface du circuit de contrôle côté plots métalliques ; et
une étape de dépôt d'au moins une deuxième couche métallique sur sensiblement toute la surface de la deuxième couche semiconductrice opposée à la première couche semiconductrice.

Selon un mode de réalisation, la formation des tranchées comprend :
une première étape de gravure de tranchées partielles traversant l'empilement actif sur toute sa hauteur et débouchant sur la face supérieure de la première ou deuxième couche métallique ; et
une deuxième étape de gravure au cours de laquelle les tranchées partielles sont prolongées à travers les première et deuxième couches métalliques.

Selon un mode de réalisation, la couche isolante comprend une première partie déposée sur les flancs des tranchées partielles, entre les première et deuxième étapes de gravure, et une deuxième partie déposée sur les flancs des tranchées après la deuxième étape de gravure.

Selon un mode de réalisation, à l'étape d), le retrait partiel de la couche isolante est réalisé par gravure anisotrope.

Selon un mode de réalisation, lors de la mise en oeuvre de l'étape a), l'empilement actif est supporté par un substrat de support situé du côté de la première couche semiconductrice opposé à la deuxième couche semiconductrice, le procédé comprenant en outre, entre l'étape a) et l'étape b), une étape de retrait du substrat de support.

Selon l'invention, la métallisation formée à l'étape e) comble entièrement les tranchées.

Selon un mode de réalisation, les diodes semiconductrices sont des diodes électroluminescentes.

Selon un mode de réalisation, les diodes sont des photodiodes.

Selon un mode de réalisation, les première et deuxième couches semiconductrices sont des couches de nitrure de gallium, les diodes étant des diodes au nitrure de gallium.

Selon un mode de réalisation, le circuit de contrôle est formé dans et sur un substrat semiconducteur.

Un autre mode de réalisation ne faisant pas partie de l'invention telle que revendiquée prévoit un dispositif optoélectronique, comportant :
un circuit intégré de contrôle comportant une pluralité de plots métalliques de connexion ;
sur le circuit de contrôle, un empilement actif de diode comportant au moins des première et deuxième couches semiconductrices dopées de types de conductivité opposés, la deuxième couche de l'empilement étant électriquement connectée aux plots métalliques du circuit de contrôle ;
des tranchées s'étendant dans l'empilement actif et délimitant dans l'empilement actif une pluralité de diodes connectées à des plots métalliques distincts du circuit de contrôle ;
une couche isolante revêtant les parois latérales des tranchées à l'exception d'au moins une partie des flancs des portions de la première couche semiconductrice délimitées par les tranchées ; et
une métallisation revêtant les parois latérales et le fond des tranchées et contactant les flancs des portions de la première couche semiconductrice délimitées par les tranchées.

Un autre mode de réalisation selon l'invention prévoit un procédé de fabrication selon la revendication 1 d'un dispositif optoélectronique, comportant les étapes suivantes :
a) rapporter, sur une face d'un circuit intégré de contrôle comportant une pluralité de plots métalliques de connexion, un empilement actif de diode comportant au moins des première et deuxième couches semiconductrices dopées de types de conductivité opposés, de façon que la deuxième couche de l'empilement soit électriquement connectée aux plots métalliques du circuit de contrôle ;
b) déposer un masque sur la face de l'empilement actif opposée au circuit de contrôle ;
c) former dans l'empilement actif, par gravure à travers des ouvertures préalablement formées dans le masque, des tranchées délimitant une pluralité de diodes connectées à des plots métalliques distincts du circuit de contrôle ;
d) déposer une couche isolante sur les parois latérales des tranchées ;
e) retirer partiellement la couche isolante de façon à libérer les flancs des portions de la première couche semiconductrice délimitées par les tranchées tout en conservant au moins une partie de l'épaisseur du masque ;
f) déposer, sur la face supérieure du masque et dans les tranchées, une couche métallique d'épaisseur suffisante pour combler entièrement les tranchées ; et
g) retirer, par polissage mécano-chimique, la couche métallique sur la face supérieure du masque et une partie de l'épaisseur du masque, de façon à ne conserver de la couche métallique qu'une métallisation revêtant les parois latérales et le fond des tranchées et contactant les flancs des portions de la première couche semiconductrice délimitées par les tranchées.

Selon un mode de réalisation, à l'étape e), le retrait partiel de la couche isolante est réalisé par gravure anisotrope verticale.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

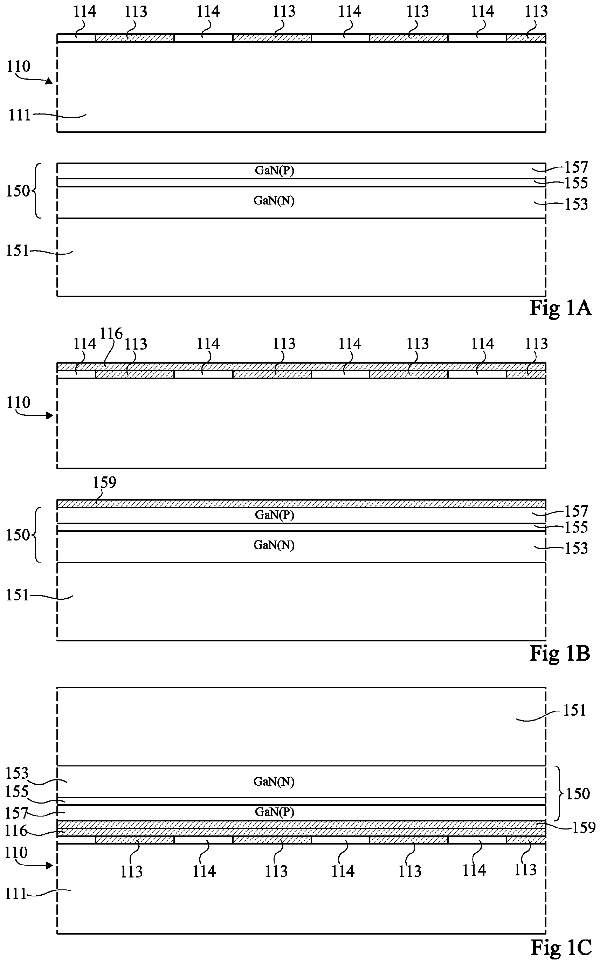

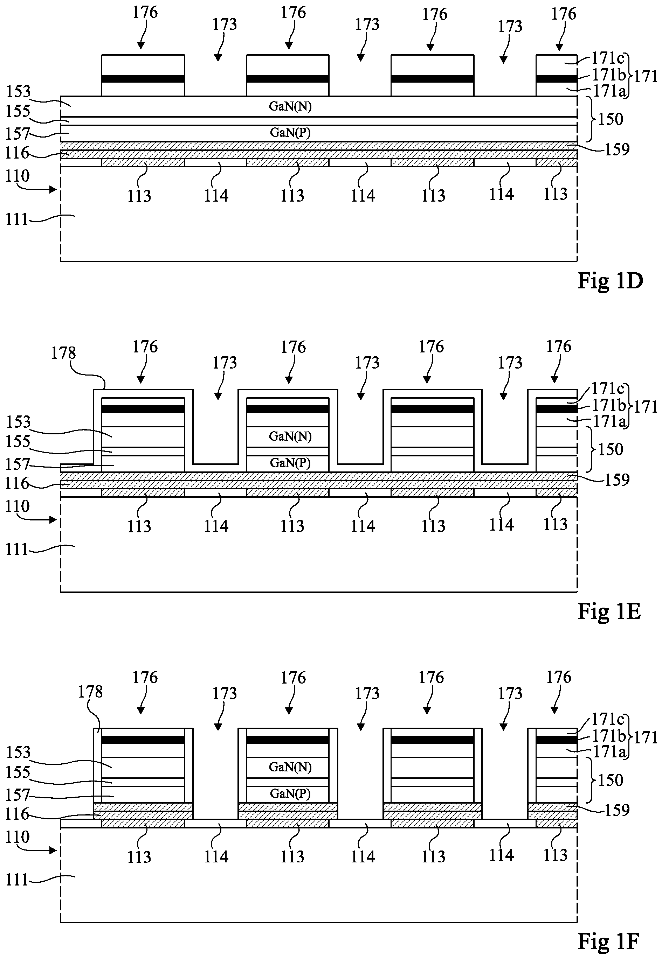

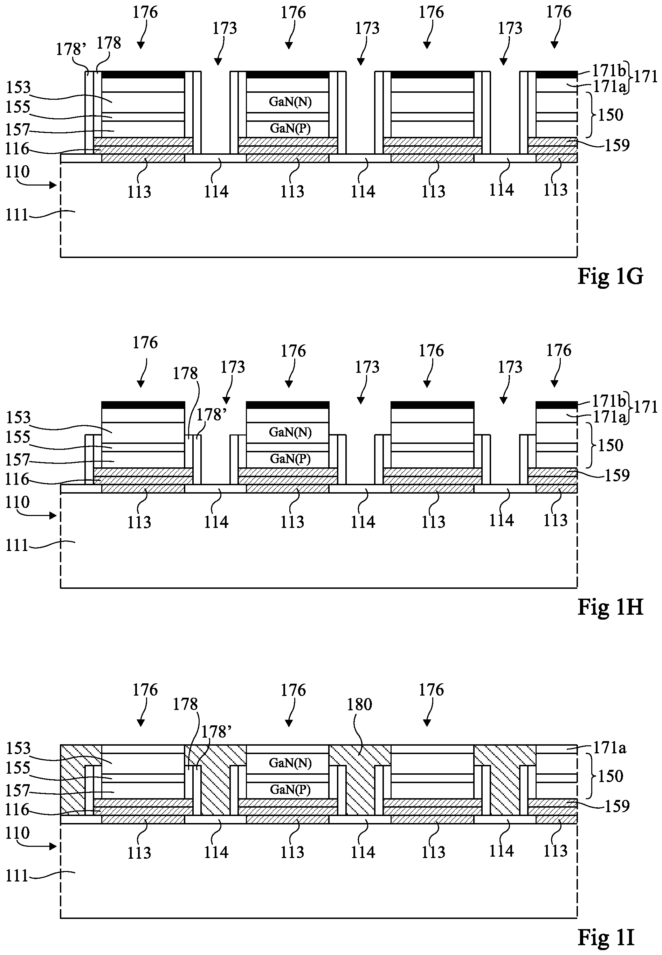

les figures 1A, 1B, 1C, 1D, 1E, 1F, 1G, 1H et 1I sont des vues en coupe illustrant des étapes d'un exemple d'un mode de réalisation d'un procédé de fabrication d'un dispositif optoélectronique.

### Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés. En particulier, la réalisation d'un circuit intégré de contrôle de diodes semiconductrices n'a pas été détaillée, les modes de réalisation décrits étant compatibles avec les structures et procédés de fabrication usuels de tels circuits de contrôle. De plus, la composition et l'agencement des différentes couches d'un empilement actif de diode semiconductrice n'ont pas été détaillés, les modes de réalisation décrits étant compatibles avec les empilements actifs usuels de diodes semiconductrices, notamment au nitrure de gallium. Dans la description qui suit, sauf indication contraire, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", "latéral", etc., il est fait référence à l'orientation des figures correspondantes, étant entendu que, dans la pratique, les dispositifs et assemblages décrits peuvent être orientés différemment. Sauf précision contraire, les expressions "approximativement", "sensiblement", et "de l'ordre de" signifient à 10 % près, de préférence à 5 % près.

Les figures 1A, 1B, 1C, 1D, 1E, 1F, 1G, 1H et 1I sont des vues en coupe illustrant des étapes d'un exemple d'un mode de réalisation d'un procédé de fabrication d'un dispositif optoélectronique.

La figure 1A représente de façon schématique un circuit intégré de contrôle 110, préalablement formé dans et sur un substrat semiconducteur 111, par exemple un substrat en silicium. Dans cet exemple, le circuit de contrôle 110 comprend, du côté de sa face supérieure, pour chacune des LED du dispositif, un plot métallique de connexion 113 destiné à être connecté à l'une des électrodes (anode ou cathode) de la LED, de façon à pouvoir commander un courant circulant dans la LED et/ou appliquer une tension aux bornes de la LED. Le circuit de contrôle comprend par exemple pour chaque LED, connectée au plot métallique 113 dédié à la LED, une cellule élémentaire de contrôle comportant un ou plusieurs transistors, permettant de contrôler le courant circulant dans la LED et/ou une tension appliquée aux bornes de la LED. Le circuit de contrôle 110 est par exemple réalisé en technologie CMOS. Les plots métalliques 113 peuvent être latéralement entourés par un matériau isolant 114, par exemple de l'oxyde de silicium, de façon que le circuit de contrôle 110 présente une surface supérieure sensiblement plane comprenant une alternance (ou damier) de régions métalliques 113 et de régions isolantes 114. Le contact sur les électrodes des LED (cathodes ou anodes), non connectées aux plots 113, peut être pris de façon collective, par exemple dans une région périphérique du circuit de contrôle 110, par l'intermédiaire d'un ou plusieurs plots de connexion (non visibles sur la figure) du circuit de contrôle 110.

La figure 1A représente en outre de façon schématique un empilement actif de LED au nitrure de gallium 150, disposé sur la face supérieure d'un substrat de support 151. Le substrat de support 151 est par exemple un substrat en silicium, en saphir, en corindon, ou en tout autre matériau sur lequel un empilement actif de LED au nitrure de gallium peut être déposé. Dans l'exemple représenté, l'empilement actif comprend, dans l'ordre à partir de la surface supérieure du substrat 151, une couche de nitrure de gallium dopé de type N 153, une couche émissive 155, et une couche de nitrure de gallium dopé de type P 157. La couche émissive 155 est par exemple constituée par un empilement d'une ou plusieurs couches émissives formant chacune un puits quantique, par exemple à base de GaN, InN, InGaN, AlGaN, AlN, AlInGaN, GaP, AlGaP, AlInGaP, ou d'une combinaison d'un ou plusieurs de ces matériaux. A titre de variante, la couche émissive 155 peut être une couche de nitrure de gallium intrinsèque, c'est-à-dire non intentionnellement dopé, par exemple de concentration en donneurs résiduels comprise entre 10¹⁵ et 10¹⁸ atomes/cm³, par exemple de l'ordre de 10¹⁷ atomes/cm³. Dans cet exemple, la face inférieure de la couche émissive 155 est en contact avec la face supérieure de la couche 153, et la face supérieure de la couche émissive 155 est en contact avec la face inférieure de la couche 157. En pratique, selon la nature du substrat 151, un empilement d'une ou plusieurs couches tampon (non représentées) peut faire interface entre le substrat de support 151 et la couche de nitrure de gallium 153. L'empilement actif 150 est par exemple déposé par épitaxie sur le substrat de support 151.

La figure 1B illustre une étape de dépôt, sur la face supérieure du circuit de contrôle 110, d'une couche métallique 116. Dans l'exemple représenté, la couche métallique 116 revêt sensiblement toute la surface supérieure du circuit de contrôle 110. En particulier, la couche métallique 116 est en contact avec les plots métalliques de connexion 113 du circuit de contrôle 110.

La figure 1B illustre en outre une étape de dépôt, sur la face supérieure de l'empilement actif de diode au nitrure de gallium 150, d'une couche métallique 159. Dans l'exemple représenté, la couche métallique 159 est disposée sur et en contact avec la face supérieure de la couche de nitrure de gallium 157. La couche métallique 159 revêt par exemple sensiblement toute la surface supérieure de l'empilement actif.

La figure 1C illustre une étape au cours de laquelle l'empilement actif de LED au nitrure de gallium 150 est rapporté sur la face supérieure du circuit de contrôle 110. Pour cela, l'ensemble comportant le substrat de support 151 et l'empilement actif 150 peut être retourné, puis rapporté sur le circuit de contrôle 110, de façon à mettre en contact la face supérieure (dans l'orientation de la figure 1B) de la couche métallique 159 en contact avec la face supérieure de la couche métallique 116. Au cours de cette étape, l'empilement actif 150 est fixé (bonded) au circuit de contrôle 110. A titre d'exemple, la fixation de l'empilement actif 150 sur le circuit de contrôle 110 peut être obtenue par collage moléculaire entre les deux surfaces mises en contact. A titre de variante, la fixation des deux surfaces peut être réalisée par thermocompression, collage eutectique, ou par toute autre méthode de fixation adaptée.

Une fois l'empilement actif de LED 150 fixé sur la face supérieure du circuit de contrôle 110, le substrat de support 151 de l'empilement actif de LED est retiré de façon à découvrir la face supérieure de la couche de nitrure de gallium 153. Le substrat 151 est par exemple retiré par meulage et/ou gravure à partir de sa face opposée à l'empilement actif 150. A titre de variante, dans le cas d'un substrat 151 transparent, par exemple un substrat en saphir ou en corindon, le substrat 151 peut être détaché de l'empilement actif 150 au moyen d'un faisceau laser projeté à travers le substrat 151 depuis sa face opposée à l'empilement actif 150 (procédé de type laser lift-off). Plus généralement, toute autre méthode permettant de retirer le substrat 151 peut être utilisée. Après le retrait du substrat 151, une étape supplémentaire de gravure peut être prévue pour retirer d'éventuelles couches tampon subsistant du côté de la face supérieure de la couche de nitrure de gallium 153. En outre, une partie de l'épaisseur de la couche de nitrure de gallium 153 peut être retirée, par exemple par gravure. A l'issue de cette étape, l'empilement actif 150 revêt sensiblement toute la surface du circuit de contrôle 110, sans discontinuité. A titre d'exemple, l'épaisseur de l'empilement actif 150 après le retrait du substrat de support 151 est comprise entre 0,5 et 10 µm.

La figure 1D illustre une étape postérieure au retrait du substrat 151, de dépôt d'un masque dur 171 sur la face supérieure (dans l'orientation de la figure 1D) de l'empilement actif de LED 150. Dans cet exemple, le masque dur 171 est constitué d'un empilement comprenant, dans l'ordre à partir de la face supérieure de la couche de nitrure de gallium de type N 157, une première couche d'oxyde de silicium 171a, une couche intermédiaire d'arrêt de gravure 171b, et une deuxième couche d'oxyde de silicium 171c. La couche intermédiaire 171b est en un matériau relativement difficilement gravable par rapport à l'oxyde de silicium, par exemple de l'aluminium, de l'alumine, ou du nitrure. A titre d'exemple, la couche intermédiaire 171b a une épaisseur comprise entre 10 et 500 nm, par exemple de l'ordre de 100 nm.

La figure 1D illustre en outre une étape de formation d'ouvertures ou tranchées traversantes 173 dans le masque dur 171, par exemple par photolithographie puis gravure. Les tranchées 173 s'étendent depuis la face supérieure du masque dur 171 et débouchent sur la face supérieure de l'empilement actif de LED 150. Les tranchées 173 délimitent, en vue de dessus, les futures LED individuelles 176 du dispositif d'affichage.

La figure 1E illustre une étape de prolongement, à travers l'empilement actif de LED 150, des tranchées 173 préalablement formées dans le masque dur 171. A titre d'exemple, les tranchées 173 sont prolongées verticalement par gravure à travers les couches 153, 155 et 157 de l'empilement de LED 150, la gravure étant interrompue sur la face supérieure de la couche métallique 159. Lors de cette étape de gravure, la couche supérieure d'oxyde de silicium 171c du masque dur 171 peut être partiellement ou totalement consommée. Les couches 171b et 171a sont en revanche préservées. Le prolongement des tranchées 173 à travers l'empilement actif 150 conduit à délimiter dans l'empilement actif 150 une pluralité de LED au nitrure de gallium 176. Chaque LED 176 correspond à un îlot ou mesa formé dans l'empilement 150 et entouré latéralement par une tranchée 173. Ainsi, chaque LED 176 comprend un empilement vertical comportant, dans l'ordre à partir de la surface supérieure de la couche métallique 159, une portion de la couche de nitrure de gallium 157, correspondant à l'anode de la LED dans cet exemple, une portion de la couche émissive 155, et une portion de la couche de nitrure de gallium 153, correspondant à la cathode de la LED dans cet exemple. Les tranchées 173 peuvent être alignées par rapport à des repères préalablement formés sur le circuit de contrôle 110. Plus particulièrement, à l'étape de la figure 1D, après le dépôt du masque dur 171 mais avant la formation des tranchées 173, des repères préalablement formés sur le substrat 111 peuvent être dégagés par gravure du masque dur 171 et de l'empilement actif 150 dans des zones périphériques de l'assemblage, ces repères servant ensuite de marques d'alignement pour le positionnement du masque de photolithographie utilisé pour réaliser les tranchées 173. Dans l'exemple représenté, chaque LED 176 est située, en projection verticale, en regard d'un unique plot métallique 113 du circuit de contrôle 110. Dans cet exemple, les tranchées 173 sont situées, en projection verticale, en regard des régions isolantes 114 de la face supérieure du circuit de contrôle 110.

La figure 1E illustre en outre une étape de dépôt d'une couche isolante 178, par exemple en oxyde de silicium, sur les parois latérales et sur le fond des tranchées 173. Dans l'exemple représenté, la couche 178 est en outre déposée sur la face supérieure des portions du masque dur 171 surmontant les LED 176. La couche 178 est par exemple déposée sur toute la surface supérieure du dispositif par une méthode de dépôt conforme, par exemple par dépôt en couches monoatomiques successives (ALD). A titre d'exemple, l'épaisseur de la couche isolante 178 est comprise entre 10 nm et 1 µm.

La figure 1F illustre une étape de retrait de la couche isolante 178 au fond des tranchées 173. Lors de cette étape, la couche 178 est conservée sur les parois latérales des tranchées 173. Pour cela, la couche 178 est par exemple gravée par gravure anisotrope verticale, ce qui conduit en outre à retirer la couche 178 sur la face supérieure des portions du masque dur 171 surmontant les LED 176.

La figure 1F illustre de plus une étape de retrait, par exemple par gravure, des portions des couches métalliques 159 et 116 situées au fond des tranchées 173, de façon à prolonger les tranchées 173 jusqu'aux régions isolantes 114 de la face supérieure du circuit de contrôle 110. A l'issue de cette étape, les anodes (régions 157) des différentes LED 176 sont isolées électriquement les unes des autres par les tranchées 173, et chaque LED 176 a son anode connectée au plot métallique 113 sous-jacent par l'intermédiaire des portions de couches métalliques 159 et 116 subsistant entre la LED et le plot 113. Ceci permet un contrôle individuel des LED par le circuit de contrôle 110.

La figure 1G illustre une étape ultérieure de dépôt, sur les parois latérales des tranchées 173, d'une deuxième couche isolante 178', par exemple en oxyde de silicium. La couche 178' est par exemple déposée sur toute la surface supérieure de l'assemblage par une technique de dépôt conforme, puis retirée uniquement sur la face supérieure des LED 176 et au fond des tranchées 173, par exemple par gravure anisotrope.

La figure 1H illustre une étape ultérieure de retrait des couches isolantes 178 et 178' sur une partie supérieure des flancs des LED 176. Plus particulièrement, lors de cette étape, les couches isolantes 178 et 178' sont retirées sur tout ou partie des flancs de la région de cathode 153 de chaque LED 176, de façon à libérer l'accès aux flancs de la région de cathode 153 de la LED. A titre d'exemple, les couches isolantes 178 et 178' sont retirées sur sensiblement toute la hauteur des flancs des régions de cathode 153 des LED 176. Les couches 178 et 178' sont en revanche conservées sur les flancs d'une partie inférieure de chaque LED 176, et en particulier sur toute la hauteur de la région émissive 155 et de la région d'anode 157 de chaque LED 176. De plus, la couche 178' est conservée sur les flancs des couches métalliques 116 et 159. A titre d'exemple, le retrait des couches 178 et 178' sur la partie supérieure des flancs des LED 176 est réalisé par gravure anisotrope verticale. Le procédé de gravure est de préférence choisi de façon à graver sélectivement l'oxyde de silicium par rapport au matériau de la couche intermédiaire 171b du masque dur 171. A titre d'exemple, la couche supérieure d'oxyde de silicium 171c du masque dur 171 est entièrement consommée lors de cette étape, tandis que la couche 171b est préservée et permet de protéger la partie inférieure 171a du masque dur 171. Les modes de réalisation décrits ne se limitent toutefois pas à ce cas particulier. A titre de variante, le masque dur 171 peut être constitué uniquement d'oxyde de silicium, pour autant que son épaisseur soit suffisamment importante pour protéger la face supérieure des LED 176 lors de l'étape de gravure anisotrope verticale de la figure 1H.

La figure 1I illustre une étape ultérieure de dépôt d'une métallisation 180 sur les parois latérales et sur le fond des tranchées 173. La métallisation 180 comble entièrement les tranchées 173. A titre d'exemple, la métallisation 180 est réalisée par un procédé de type damascène, comprenant une étape de dépôt d'une couche métallique sur toute la surface supérieure de l'assemblage sur une épaisseur suffisante pour combler les tranchées 173, suivie d'une étape de polissage mécanochimique de la face supérieure de l'assemblage pour planariser la face supérieure du dispositif et retirer les portions de la couche métallique surmontant les LED 176. Dans cet exemple, la couche d'arrêt de gravure 171b du masque dur 171 est en outre retirée lors de l'étape de polissage mécanochimique. A titre d'exemple, seule la couche d'oxyde de silicium inférieure 171a ou une partie de l'épaisseur de la couche 171a est conservée et sert de couche de passivation de la face supérieure des régions de cathode 153 des LED 176. La métallisation 180 est par exemple constituée d'une couche inférieure d'accroche, comprenant par exemple un empilement Aluminium/Titane/Nitrure de Titane/Cuivre d'épaisseur comprise entre 10 et 100 nm, par exemple d'épaisseur de l'ordre de 50 nm, et d'une couche supérieure de remplissage, par exemple en cuivre, déposée par dépôt électrochimique. La métallisation 180 est en contact avec les flancs de la région de cathode 153 de chaque LED 176 du dispositif d'affichage, sur sensiblement toute la périphérie de la LED. La métallisation 180 est en revanche isolée des flancs des régions d'anode 157 et des régions émissives 155 des LED par les couches isolantes 178 et 178'. Dans cet exemple, la métallisation 180 forme, en vue de dessus, une grille conductrice continue interconnectant les régions de cathode 153 de toutes les LED du dispositif. La métallisation 180 est par exemple connectée au circuit de contrôle 110 dans une région périphérique du dispositif d'affichage.

Dans l'exemple de réalisation décrit en relation avec les figures 1A à 1I, le dépôt des couches métalliques 116 et 159 sur le circuit de contrôle 110 et sur l'empilement actif 150 (étape de la figure 1B) préalablement au report de l'empilement actif 150 sur le circuit de contrôle 110 (étape de la figure 1C) présente plusieurs avantages.

En particulier, les couches 116 et 159 permettent d'améliorer la qualité du collage entre les deux structures. En effet, bien que possible, le collage direct de la face supérieure (dans l'orientation de la figure 1A) de la couche de nitrure de gallium 157 sur la surface supérieure du circuit de contrôle 110 (comprenant une alternance de régions isolantes 114 et de régions métalliques 113) est relativement délicat à réaliser.

En outre, la couche 159 peut avantageusement être choisie pour réaliser un bon contact ohmique avec la couche de nitrure de gallium 157. Le matériau des plots métalliques 113 du circuit de contrôle 110, par exemple du cuivre ou de l'aluminium, peut en effet ne pas être adapté à la réalisation d'un tel contact ohmique.

De plus, les couches 116 et/ou 159 peuvent comprendre un métal réfléchissant pour la lumière émise par les LEDs 176, de façon à augmenter l'efficacité d'émission et éviter des déperditions de lumière dans le circuit de contrôle 110.

Par ailleurs, la couche 116 et/ou la couche 159 peuvent être choisies de façon à éviter que du métal des plots de connexion 113 du circuit de contrôle, par exemple du cuivre, ne diffuse vers la couche de nitrure de gallium 157, ce qui pourrait notamment dégrader la qualité du contact ohmique avec la couche de nitrure de gallium 157.

En pratique, chacune des couches 116 et 159 peut être une couche unique ou un empilement d'une ou plusieurs couches de métaux différents permettant d'assurer tout ou partie des fonctions susmentionnées.

A titre d'exemple, la couche 116 comprend une couche supérieure en un métal de même nature qu'une couche supérieure (dans l'orientation de la figure 1B) de la couche 159, ce métal étant choisi pour obtenir un bon collage entre les deux structures lors de l'étape de la figure 1C, par exemple un métal du groupe comprenant le Ti, le Ni, le Pt, le Sn, l'Au, l'Ag, l'Al, le Pd, le W, le Pb, le Cu, l'AuSn, le TiSn, le NiSn ou un alliage de tout ou partie de ces matériaux. L'empilement formé par les couches 116 et 159 peut en outre comprendre une ou plusieurs couches en des métaux adaptés à réfléchir la lumière émise par les LEDs, par exemple de l'argent. De plus, l'empilement formé par les couches 116 et 159 peut comprendre une ou plusieurs couches adaptées à faire barrière à la diffusion de métaux tels que le cuivre ou l'argent compris dans l'empilement 116/159 et/ou dans les plots métalliques 113, par exemple des couches de TaN, TiN, WN, TiW, ou d'une combinaison de tout ou partie de ces matériaux.

En variante, la couche 116 et/ou la couche 159 peuvent toutefois être omises. De préférence, au moins l'une des couches 116 et 159 est prévue, de préférence la couche 159 formée côté empilement actif de LED 150.

Un avantage du procédé décrit en relation avec les figures 1A à 1I est qu'il présente une unique étape de photolithographie et gravure (pour définir l'emplacement des tranchées 113), ce qui le rend particulièrement simple et peu coûteux à mettre en oeuvre.

Un autre avantage de ce procédé est que le contact électrique de cathode des LED 176 est pris latéralement sur toute la périphérie des régions de cathode 153 des LED. Ceci permet de minimiser la résistance de contact de cathode, et ainsi de limiter la consommation électrique du dispositif.

Par ailleurs, la disposition des métallisations de contact de cathode 180 dans les tranchées d'isolation des LED 176 permet de maximiser la surface active du dispositif d'affichage. Cette disposition permet en outre de renforcer l'isolation optique entre les différentes LED 176, et de favoriser l'évacuation de la chaleur générée par les LED 176 en fonctionnement.

On notera que, dans le procédé décrit en relation avec les figures 1A à 1I, le dépôt de la couche 178 à l'étape de la figure 1E permet avantageusement de protéger les flancs de l'empilement actif de LED 150 lors de l'étape ultérieure de gravure des couches métalliques 159 et 116 à l'étape de la figure 1F. A titre de variante, le dépôt de la couche isolante 178 peut toutefois être omis. Dans ce cas, seule la couche 178' déposée à l'étape de la figure 1G revêt les flancs des LED 176 lors de l'étape de dégagement des flancs des régions de cathode 153 des LED illustrée par la figure 1G.

Des modes de réalisation particuliers ont été décrits. Diverses variantes et modifications apparaîtront à l'homme de l'art. En particulier, les types de conductivité des couches de nitrure de gallium 153 (de type N dans les exemples décrits) et 157 (de type P dans les exemples décrits) peuvent être inversés.

Par ailleurs, bien que l'on ait décrit uniquement des exemples de réalisation de dispositifs d'affichage à base de LED au nitrure de gallium, les modes de réalisation décrits peuvent être adaptés à la fabrication d'un capteur comportant une pluralité de photodiodes au nitrure de gallium adressables individuellement pour acquérir une image.

Plus généralement, les modes de réalisation décrits peuvent être adaptés à la fabrication de tout dispositif d'affichage ou capteur photosensible à base de diodes semiconductrices, y compris à base de matériaux semiconducteurs autres que le nitrure de gallium, par exemple des diodes à base d'autres matériaux semiconducteurs III-V ou des diodes à base de silicium.

## Revendications

1. Procédé de fabrication d'un dispositif optoélectronique, comportant les étapes suivantes :
a) rapporter, sur une face d'un circuit intégré de contrôle (110) comportant une pluralité de plots métalliques (113) de connexion, un empilement actif (150) de diode comportant au moins des première (153) et deuxième (157) couches semiconductrices dopées de types de conductivité opposés, de façon que la deuxième couche (157) de l'empilement soit électriquement connectée aux plots métalliques (113) du circuit de contrôle (110) ;
b) déposer un masque dur (171) sur la face de l'empilement actif (150) opposée au circuit de contrôle (113) ;
c) former dans l'empilement actif (150), par gravure à travers des ouvertures préalablement formées dans le masque (171), des tranchées (173) délimitant une pluralité de diodes (176) connectées à des plots métalliques (113) distincts du circuit de contrôle (110) ;
d) déposer une couche isolante (178, 178') sur les parois latérales des tranchées (173) ;
e) retirer partiellement la couche isolante (178, 178') de façon à libérer les flancs des portions de la première couche semiconductrice (153) délimitées par les tranchées (173) tout en conservant au moins une partie de l'épaisseur du masque (171) ;
f) déposer, sur la face supérieure du masque (171) et dans les tranchées (173), une couche métallique d'épaisseur suffisante pour combler entièrement les tranchées (173) ; et
g) retirer, par polissage mécano-chimique, la couche métallique sur la face supérieure du masque (171), de façon à ne conserver de la couche métallique qu'une métallisation (180) revêtant les parois latérales et le fond des tranchées (173) et contactant les flancs des portions de la première couche semiconductrice (153) délimitées par les tranchées.

2. Procédé selon la revendication 1, comportant en outre, avant l'étape a), au moins l'une des étapes suivantes :
une étape de dépôt d'au moins une première couche métallique (116) sur sensiblement toute la surface du circuit de contrôle (110) côté plots métalliques (113) ; et
une étape de dépôt d'au moins une deuxième couche métallique (159) sur sensiblement toute la surface de la deuxième couche (157) semiconductrice opposée à la première couche (153) semiconductrice.

3. Procédé selon la revendication 2, dans lequel la formation des tranchées (173) comprend :
une première étape de gravure de tranchées partielles traversant l'empilement actif (150) sur toute sa hauteur et débouchant sur la face supérieure de la première (116) ou deuxième (159) couche métallique ; et
une deuxième étape de gravure au cours de laquelle les tranchées partielles sont prolongées à travers les première (116) et deuxième (159) couches métalliques.

4. Procédé selon la revendication 3, dans lequel la couche isolante (178, 178') comprend une première partie (178) déposée sur les flancs des tranchées partielles, entre les première et deuxième étapes de gravure, et une deuxième partie (178') déposée sur les flancs des tranchées (173) après la deuxième étape de gravure.

5. Procédé selon l'une quelconque des revendications 1 à 4, dans lequel, à l'étape e), le retrait partiel de la couche isolante (178, 178') est réalisé par gravure anisotrope.

6. Procédé selon l'une quelconque des revendications 1 à 5, dans lequel, lors de la mise en oeuvre de l'étape a), l'empilement actif (150) est supporté par un substrat de support (151) situé du côté de la première couche (153) semiconductrice opposé à la deuxième couche (157) semiconductrice, le procédé comprenant en outre, entre l'étape a) et l'étape b), une étape de retrait du substrat de support (151).

7. Procédé selon l'une quelconque des revendications 1 à 6, dans lequel lesdites diodes (176) semiconductrices sont des diodes électroluminescentes.

8. Procédé selon l'une quelconque des revendications 1 à 6, dans lequel lesdites diodes sont des photodiodes.

9. Procédé selon l'une quelconque des revendications 1 à 8, dans lequel les première (153) et deuxième (157) couches semiconductrices sont des couches de nitrure de gallium, lesdites diodes (176) étant des diodes au nitrure de gallium.

10. Procédé selon l'une quelconque des revendications 1 à 9, dans lequel le circuit de contrôle (110) est formé dans et sur un substrat semiconducteur (111).

## Patentansprüche

1. Verfahren zur Herstellung einer optoelektronischen Vorrichtung, wobei das Verfahren die folgenden Schritte aufweist:
a) Übertragen eines aktiven Diodenstapels (150), der mindestens eine erste (153) und eine zweite (157) dotierte Halbleiterschicht mit entgegengesetzten Leitfähigkeitstypen aufweist, auf eine Oberfläche einer integrierten Steuerschaltung (110), die eine Vielzahl von Metallanschlussflächen (113) umfasst, so dass die zweite Schicht (157) des Stapels elektrisch mit den Metallanschlussflächen (113) der Steuerschaltung (110) verbunden ist;
b) Aufbringen einer Hartmaske (171) auf die Oberfläche des aktiven Stapels (150) gegenüber der Steuerschaltung (113);
c) Ausbilden von Gräben (173) in dem aktiven Stapel (150) durch Ätzen über zuvor in der Maske (171) ausgebildete Öffnungen, die eine Vielzahl von Dioden (176) begrenzen, die mit separaten Metallanschlussflächen (113) der Steuerschaltung (110) verbunden sind;
d) Aufbringen einer Isolierschicht (178, 178') auf die Seitenwände der Gräben (173);
e) teilweises Entfernen der Isolierschicht (178, 178'), um die Seiten der Abschnitte der ersten Halbleiterschicht (153), die durch die Gräben (173) begrenzt sind, freizulegen, wobei mindestens ein Teil der Dicke der Maske (171) erhalten bleibt;
f) Aufbringen einer Metallschicht auf der Oberseite der Maske (171) und in den Gräben (173) mit einer ausreichenden Dicke, um die Gräben (173) vollständig zu füllen; und
g) Entfernen der Metallschicht auf der Oberseite der Maske (171) durch chemisch-mechanisches Polieren, so dass von der Metallschicht nur eine Metallisierung (180) übrig bleibt, die die Seitenwände und den Boden der Gräben (173) bedeckt und die Seiten der von den Gräben begrenzten Teile der ersten Halbleiterschicht (153) kontaktiert.

2. Verfahren nach Anspruch 1, das außerdem vor Schritt a) mindestens einen der folgenden Schritte aufweist:
einen Schritt des Aufbringens mindestens einer ersten Metallschicht (116) über im Wesentlichen die gesamte Oberfläche der Steuerschaltung (110) auf der Seite der Metallanschlussflächen (113); und
einen Schritt des Aufbringens mindestens einer zweiten Metallschicht (159) auf im Wesentlichen der gesamten Oberfläche der zweiten Halbleiterschicht (157) gegenüber der ersten Halbleiterschicht (153).

3. Verfahren nach Anspruch 2, wobei das Ausbilden der Gräben (173) Folgendes aufweist:
einen ersten Schritt des Ätzens von Teilgräben, die den aktiven Stapel (150) über seine gesamte Höhe durchdringen und auf der oberen Oberfläche der ersten (116) oder (159) zweiten Metallschicht austreten; und
einen zweiten Ätzschritt, bei dem die Teilgräben durch die erste (116) und zweite (159) Metallschicht fortgesetzt werden.

4. Verfahren nach Anspruch 3, wobei die Isolierschicht (178, 178') einen ersten Teil (178) aufweist, der auf den Seiten der Teilgräben zwischen dem ersten und dem zweiten Ätzschritt abgeschieden wird, und einen zweiten Teil (178') aufweist, der auf den Seiten der Gräben (173) nach dem zweiten Ätzschritt abgeschieden wird.

5. Verfahren nach einem der Ansprüche 1 bis 4, wobei in Schritt e) die teilweise Entfernung der Isolierschicht (178, 178') durch anisotropes Ätzen erfolgt.

6. Verfahren nach einem der Ansprüche 1 bis 5, wobei während der Durchführung von Schritt a) der aktive Stapel (150) von einem Trägersubstrat (151) getragen wird, das sich auf der Seite der ersten Halbleiterschicht (153) befindet, die der zweiten Halbleiterschicht (157) gegenüberliegt, wobei das Verfahren ferner zwischen Schritt a) und Schritt b) einen Schritt zum Entfernen des Trägersubstrats (151) aufweist.

7. Verfahren nach einem der Ansprüche 1 bis 6, wobei die Halbleiterdioden (176) lichtemittierende Dioden sind.

8. Verfahren nach einem der Ansprüche 1 bis 6, wobei es sich bei den Dioden um Fotodioden handelt.

9. Verfahren nach einem der Ansprüche 1 bis 8, wobei die erste (153) und die zweite (157) Halbleiterschicht Galliumnitridschichten sind und die Dioden (176) Galliumnitriddioden sind.

10. Verfahren nach einem der Ansprüche 1 bis 9, wobei die Steuerschaltung (110) innerhalb und auf einem Halbleitersubstrat (111) ausgebildet ist.

## Claims

1. A method of manufacturing an optoelectronic device, comprising the steps of:
a) transferring, onto a surface of an integrated control circuit (110) comprising a plurality of metal connection pads (113), an active diode stack (150) comprising at least first (153) and second (157) doped semiconductor layers of opposite conductivity types, so that the second layer (157) of the stack is electrically connected to the metal pads (113) of the control circuit (110);
b) depositing a hard mask (171) on the surface of the actif stack (150) opposite to the control circuit (113);
c) forming in the active stack (150), by etching across openings previously formed in the mask (171), trenches (173) delimiting a plurality of diodes (176) connected to separate metal pads (113) of the control circuit (110);
d) depositing an insulating layer (178, 178') on the lateral walls of the trenches (173);
e) partially removing the insulating layer (178 178') to expose the sides of the portions of the first semiconductor layer (153) delimited by the trenches (173) while keeping at least part of the thickness of the mask (171) ;
f) depositing, on the upper surface of the mask (171) and in trenches (173), a metal layer having a thickness sufficient for entirely filling the trenches (173) ; and
g) removing, by chemical mechanical polishing, the metal layer on the upper surface of the mask (171), so as to keep from the metal layer only a metallization (180) coating the lateral walls and the bottom of the trenches (173) and contacting the sides of the portions of the first semiconductor layer (153) delimited by the trenches.

2. The method of claim 1, further comprising, before step a), at least one of the following steps:
a step of depositing at least one first metal layer (116) over substantially the entire surface of the control circuit (110) on the side of the metal pads (113); and
a step of depositing at least one second metal layer (159) over substantially the entire surface of the second semiconductor layer (157) opposite to the first semiconductor layer (153).

3. The method of claim 2, wherein the forming of the trenches (173) comprises:
a first step of etching partial trenches crossing the active stack (150) across its entire height and emerging onto the upper surface of the first (116) or (159) second metal layer; and
a second etch step during which the partial trenches are continued through the first (116) and second (159) metal layers.

4. The method of claim 3, wherein the insulating layer (178, 178') comprises a first portion (178) deposited on the sides of the partial trenches, between the first and second etch steps, and a second portion (178') deposited on the sides of the trenches (173) after the second etch step.

5. The method of any of claims 1 to 4, wherein, at step e), the partial removal of the insulating layer (178, 178') is performed by anisotropic etching.

6. The method of any of claims 1 to 5, wherein, during the implementation of step a), the active stack (150) is supported by a support substrate (151) located on the side of the first semiconductor layer (153) opposite to the second semiconductor layer (157), the method further comprising, between step a) and step b), a step of removing the support substrate (151).

7. The method of any of claims 1 to 6, wherein said semiconductor diodes (176) are light-emitting diodes.

8. The method of any of claims 1 to 6, wherein said diodes are photodiodes.

9. The method of any of claims 1 to 8, wherein the first (153) and second (157) semiconductor layers are gallium nitride layers, said diodes (176) being gallium nitride diodes.

10. The method of any of claims 1 to 9, wherein the control circuit (110) is formed inside and on top of a semiconductor substrate (111).
